# EUROPÄISCHE PATENTSCHRIFT

(11) **EP 3 231 095 B1**
(45) Veröffentlichungstag und Bekanntmachung des Hinweises auf die Patenterteilung: **30.01.2019**
(21) Anmeldenummer: 15805160.7
(22) Anmeldetag: 03.12.2015
(51) Int. Cl.: H04B 1/00, G01R 23/16, H03F 3/19, H03G 3/30

(54) **VERSTÄRKEREINSTELLVORRICHTUNG, SYSTEM UMFASSEND EINE VERSTÄRKEREINSTELLVORRICHTUNG UND VERFAHREN ZUM BETRIEB EINER VERSTÄRKEREINSTELLVORRICHTUNG**
AMPLIFIER SETTING DEVICE, SYSTEM COMPRISING AN AMPLIFIER SETTING DEVICE AND METHOD FOR OPERATING AN AMPLIFIER SETTING DEVICE
DISPOSITIF DE RÉGLAGE D'AMPLIFICATEUR, SYSTÈME COMPORTANT UN DISPOSITIF DE RÉGLAGE D'AMPLIFICATEUR ET PROCÉDÉ DE FONCTIONNEMENT D'UN DISPOSITIF DE RÉGLAGE D'AMPLIFICATEUR

(30) Priorität: 08.12.2014 DE 102014225148
(43) Veröffentlichungstag der Anmeldung: 18.10.2017
(73) Patentinhaber: Innovationszentrum für Telekommunikationstechnik GmbH IZT, 91058 Erlangen (DE)
(72) Erfinder: PERTHOLD, Rainer, 91085 Weisendorf (DE)
(74) Vertreter: Zimmermann, Tankred Klaus
(86) Internationale Anmeldenummer: PCT/EP2015/078561
(87) Internationale Veröffentlichungsnummer: WO 2016/091722

(56) Entgegenhaltungen:
- JP-A- 2002 214 259
- US-A- 4 607 215
- US-A1- 2012 274 309
- US-A1- 2014 294 199

## Beschreibung

Die vorliegende Erfindung bezieht sich auf eine Verstärkereinstellvorrichtung, ein System, welches eine Verstärkereinstellvorrichtung umfasst, und ein Verfahren zum Betrieb einer Verstärkereinstellvorrichtung.

Bei Spektrumanalysatoren ist es üblich, die Verstärkungseinstellung anhand eines sogenannten "Reference Levels" (dt.: Referenzpegel) vorzunehmen. Dieser Wert legt die maximale Aussteuerung über den gesamten abzusuchenden Frequenzbereich fest. Dies hat typischerweise den Nachteil, dass der Reference Level stets durch das stärkste Signal innerhalb des Suchbereichs bestimmt wird und somit vergleichbar schwache Signale unter Umständen unnötig stark gedämpft werden. Eine weitere Lösungsmöglichkeit zur Verstärkungseinstellung besteht darin, dass der Empfänger nach jedem Einstellen einer neuen Mittenfrequenz eine Messung zur Ermittlung der optimalen Verstärkung durchführt. Dies ist zwar einfach zu implementieren (z.B. mittels eines ADC (Analog-Digital Converter, dt.: Analog-Digital Wandler)), aber nachteilig, da während des Regelvorgangs keine gültigen Messergebnisse gewonnen werden können und sich somit die Zeitdauer für einen Scan unter Umständen erheblich verlängert.

US 2012/274309 beschreibt ein Beispiel eines Spektrumanalysators

Der vorliegenden Erfindung liegt somit die Aufgabe zugrunde, ein verbessertes Verstärkungsregelungskonzept zu schaffen.

Diese Aufgabe wird durch den Gegenstand der unabhängigen Patentansprüche gelöst. Erfindungsgemäße Weiterbildungen sind in den Unteransprüchen definiert.

Ausführungsbeispiele schaffen eine Verstärkereinstellvorrichtung für ein in Abhängigkeit von einem Verstärkungsfaktor einstellbaren Verstärkerelements, das mit einem Frequenzbereichsauswahlelement zur Einstellung von zumindest zwei Frequenzbereichen gekoppelt ist. Die Verstärkereinstellvorrichtung umfasst einen Speicher, in dem mindestens zwei Verstärkungsfaktoren hinterlegbar sind, wobei die mindestens zwei Verstärkungsfaktoren den zumindest zwei Frequenzbereichen zugeordnet sind. Weiterhin umfasst die Verstärkereinstellvorrichtung ein Verstärkungsfaktoreinstellelement, das ausgebildet ist, in Abhängigkeit eines aktuellen Frequenzbereichs einen entsprechenden Verstärkungsfaktor aus dem Speicher auszuwählen, um so das Verstärkerelement einzustellen. Ferner umfasst die Verstärkereinstellvorrichtung einen Verstärkungsfaktorschätzer, der ausgebildet ist, basierend auf einer Analyse eines mittels des Verstärkerelements entsprechend dem gewählten Verstärkungsfaktor verstärkten Signals den gewählten Verstärkungsfaktor zu korrigieren und den korrigierten Verstärkungsfaktor in einem Speicher abzulegen.

Der Erfindung liegt die Erkenntnis zu Grunde, dass eine Einstellung eines Verstärkers, z.B. in einem Signalpfad, hinsichtlich Einstelldauer und Genauigkeit dadurch optimiert werden kann, dass für unterschiedliche Frequenzbereiche unterschiedliche Verstärkereinstellungen vorgehalten werden, die dann im laufenden Betriebe stetig aktualisiert werden können. Ausgehend hiervon umfasst also eine Verstärkereinstellvorrichtung Mittel zur Verstärkereinstellung basierend auf vorbestimmten Verstärkereinstellwerten, welche beispielsweise in einer Nachschlagtabelle gespeichert sind, und Mittel zur Überprüfung und Anpassung der Verstärkereinstellwerte. Da die Verstärkereinstellwerte für unterschiedliche Frequenzbereiche typischerweise unterschiedlich sind, arbeiten die Mittel zur Verstärkereinstellung und die Mittel zur Überprüfung und Anpassung der Verstärkereinstellwerte frequenzselektiv. Somit ist es möglich, ab der ersten Signalverarbeitung mit annähernd passenden Verstärkereinstellwerten zu arbeiten und (z.B. bei der sequentiellen Analyse von mehreren Frequenzbändern) die Werte für jedes Frequenzband parallel zur weiteren Signalverarbeitung zu aktualisieren, ohne die Messzeit negativ zu beeinflussen.

Gemäß eines Ausführungsbeispiels ist ein System ausgebildet, welches eine Verstärkereinstellvorrichtung, ein Frequenzbereichsauswahlelement und ein einstellbares Verstärkerelement umfasst. Das Frequenzbereichsauswahlelement kann ein Signal in ein erstes Teilsignal in einem ersten Frequenzbereich und in ein zweites Teilsignal in einem zweiten Frequenzbereich teilen. Das Verstärkereinstellelement kann mit dem einstellbaren Verstärkerelement gekoppelt sein, um dasselbe mit dem Verstärkungsfaktor gemäß dem vom Frequenzbereichsauswahlelement ausgewählten Frequenzbereich einzustellen.

Gemäß eines Ausführungsbeispiels wird ein Verfahren zum Betrieb einer Verstärkereinstellvorrichtung mit einem in Abhängigkeit von einem Verstärkungsfaktor einstellbares Verstärkerelement geschaffen, das mit einem Frequenzbereichsauswahlelement zur Einstellung von zumindest zwei Frequenzbereichen gekoppelt ist. Der Betrieb ist gekennzeichnet durch den Schritt des Bereitstellens von mindestens zwei Verstärkungsfaktoren in einem Speicher, wobei die mindestens zwei Verstärkungsfaktoren den zumindest zwei Frequenzbereichen zugeordnet sind. Der Betrieb umfasst ferner den Schritt des Einstellens eines Verstärkerelements entsprechend eines in Abhängigkeit eines aktuellen Frequenzbereichs aus dem Speicher ausgewählten Verstärkungsfaktors sowie des Korrigierens des gewählten Verstärkungsfaktors basierend auf einer Analyse eines mittels des Verstärkerelements entsprechend dem gewählten Verstärkungsfaktor verstärkten Signals und Ablegen des korrigierten Verstärkungsfaktors in den Speicher. Gemäß eines Ausführungsbeispiels kann das Verfahren durch ein Computerprogramm mit einem Programmcode ausgeführt werden.

Gemäß eines Ausführungsbeispiels wird zur Korrektur der Verstärkungsfaktoren ein Korrekturfaktor berechnet, welcher in jeder Iteration angepasst werden kann. Zur Berechnung des Korrekturfaktors können also Korrekturfaktoren aus vorangegangenen Iterationen verwendet werden, z.B. in zeitlich abnehmender Gewichtung. Die zeitlich abnehmende Gewichtung kann entsprechend weiterer Ausführungsbeispiele mit einem Leaky-Integrator (dt.: Leckintegrator) erreicht werden. Somit kann der Korrekturfaktor beliebig an die Anforderungen der aktuellen Anwendung angepasst werden. Wird z.B. eine schnelle Anpassung an sich ändernde Signalstärken gewünscht, können weniger oder keine zurückliegenden Korrekturfaktoren in die Berechnung des aktuellen Korrekturfaktors einfließen und/oder die Gewichtung wird sehr klein gewählt.

Weitere Ausführungsbeispiele zeigen die Verstärkereinstellvorrichtung gemäß einem der vorherigen Ansprüche, wobei die mindestens zwei Verstärkungsfaktoren Stützstellen in Frequenz und Zeit für eine Interpolationsfunktion sind, mit derselben das einstellbare Verstärkerelement eingestellt wird. Dies ist vorteilhaft, da das Ausführungsbeispiel unabhängig von einem festen Frequenzraster ist. Somit liegt bereits ein initialer Wert für eine Verstärkung bzw. Aussteuerung vor, selbst wenn bei genau dieser Frequenz noch kein Messwert für die Aussteuerung vorliegt, da diese Frequenz noch nicht eingestellt war.

Bevorzugte Ausführungsbeispiele der vorliegenden Anmeldung werden nachfolgend Bezug nehmend auf die beiliegenden Zeichnungen näher erläutert. Es zeigen:
- Fig. 1: einen exemplarischen Signalflussplan einer Verstärkereinstellvorrichtung, einem einstellbaren Verstärkerelement sowie einem Frequenzbereichsauswahlelement gemäß eines Ausführungsbeispiels;
- Fig. 2: ein schematisches Flussdiagramm eines Verfahrens zum Betrieb einer Verstärkereinstellvorrichtung gemäß eines Ausführungsbeispiels;
- Fig. 3: einen exemplarischen Signalflussplan einer Verstärkereinstellvorrichtung mit peripheren Bausteinen gemäß eines Ausführungsbeispiels.
- Fig. 4a: ein schematisches Diagramm eines Frequenzbereichs, welcher in fünf unterschiedlich verstärkte Subbereiche untergliedert ist, zur Illustration einer Verstärkung mit konstantem Verstärkungsfaktor.
- Fig. 4b: ein schematisches Diagramm eines Frequenzbereichs, welcher in fünf unterschiedlich verstärkte Subbereiche untergliedert ist, zur Illustration einer Verstärkung mit variablem Verstärkungsfaktor.

In der nachfolgenden Beschreibung der Figuren werden gleiche oder gleichwirkende Elemente mit dem gleichen Bezugszeichen versehen, so dass deren Beschreibung in den unterschiedlichen Ausführungsbeispielen untereinander austauschbar ist.

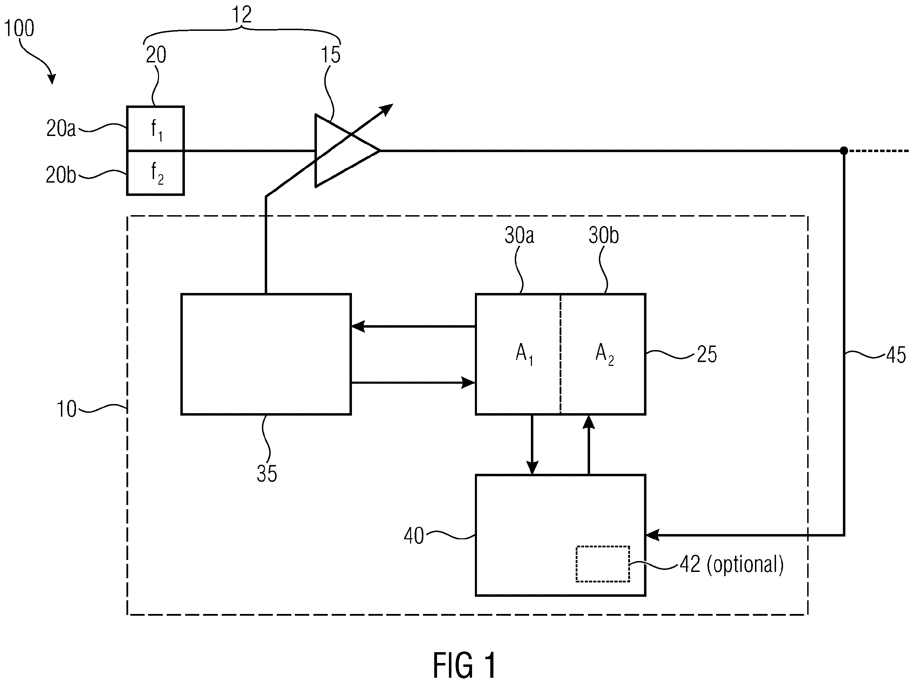

Fig. 1 zeigt einen exemplarischen Signalflussplan einer Verstärkereinstellvorrichtung 10 für einen Signalverstärkungspfad 12.

Der Signalprozessorpfad 12 umfasst ein in Abhängigkeit von einem Verstärkungsfaktor einstellbares Verstärkerelement 15, und ein Frequenzbereichsauswahlelement 20 zur Einstellung von zumindest zwei Frequenzbereichen 20a und 20b, wobei das einstellbare Verstärkerelement 15 und das Frequenzbereichsauswahlelement 20 in Reihe geschaltet sind. Mit dem Frequenzbereichsauswahlelement 20 erfolgt eine Vorauswahl des Frequenzbereiches f1 oder f2 eines mittels des Signalverstärkungspfads 12 zu bearbeitenden Signals. Bei der Signalverarbeitung erfolgt in einem Schritt eine Verstärkung des Eingangssignals, beispielsweise so, dass ein nachgeschalteter Analog-Digital Wandler in einem "guten" Aussteuerbereich betrieben werden kann. Da in unterschiedlichen Frequenzbereichen typischerweise erhebliche Signalenergieunterschiede herrschen, soll dies bei der Einstellung des einstellbaren Verstärkerelements 15 entsprechend berücksichtigt werden.

Deshalb wird dann entsprechend den ersten Ausführungsbeispielen die Verstärkereinstellvorrichtung 10 geschaffen, welche nachfolgend beschrieben wird. Die Verstärkereinstellvorrichtung 10 umfasst ein Verstärkungsfaktoreinstellelement 35, einen Speicher 25 und einen Verstärkungsfaktorschätzer 40.

Die Funktionsweise stellt sich wie folgt dar: Das Verstärkungsfaktoreinstellelement 35 und der Speicher 25, in dem mindestens zwei Verstärkungsfaktoren 30a und 30b hinterlegbar oder bereits hinterlegt sind, wobei die mindestens zwei Verstärkungsfaktoren 30a und 30b den zumindest zwei Frequenzbereichen 20a und 20b zugeordnet sind, sind informatorisch miteinander gekoppelt, sodass das Verstärkungsfaktoreinstellelement 35 in Abhängigkeit eines aktuellen Frequenzbereichs, zumindest aus den zwei Frequenzbereichen 20a und 20b oder eines weiteren Frequenzbereichs, einen entsprechenden Verstärkungsfaktor, z.B. den Verstärkungsfaktor 30a oder 30b oder einen weiteren Verstärkungsfaktor, aus dem Speicher 25 auswählen kann, um so das einstellbare Verstärkerelement 15 einzustellen.

Der Verstärkungsfaktorschätzer 40 ist ausgebildet, um basierend auf einer Analyse eines mittels des einstellbaren Verstärkerelements 15 entsprechend dem gewählten Verstärkungsfaktor verstärkten Signals 45 (kurz: Verstärkersignal 45) den gewählten Verstärkungsfaktor zu korrigieren und den korrigierten Verstärkungsfaktor wieder in dem Speicher 25 abzulegen bzw. zu aktualisieren. Im Detail liest der Verstärkungsfaktorschätzer 40 einen Verstärkungsfaktor aus dem Speicher 25 aus, korrigiert diesen und legt den korrigierten Verstärkungsfaktor in den Speicher 25 ab. Zur Analyse des Verstärkungssignals kann der Verstärkungsfaktorschätzer 40 ein in dem Signalverstärkungspfad 12 digitalisiertes Verstärkersignal 45 empfangen und auswerten oder selbst einen optionalen Analog-Digital Wandler 42 umfassen, um das (analoge) Verstärkersignal 45 nach Digitalisierung zu analysieren. Der Verstärkungsfaktorschätzer 40 kann auch als Schätzer für die Aussteuerung des einstellbaren Verstärkerelements 15 betrachtet werden.

Bei Ausführungsbeispielen kann der Verstärkerfaktorschätzer 40 ausgebildet sein, den korrigierten Verstärkungsfaktor in einer weiteren Iteration zu korrigieren, um einen zweifach korrigierten Verstärkungsfaktor zu erhalten. In jeder Iteration können unterschiedliche Korrekturfaktoren benutzt werden, die zueinander gewichtet sind. Somit wird beispielsweise verhindert, dass kurze und starke Änderungen im Signalverlauf den aktuellen Verstärkungsfaktor zu stark beeinflussen.

Der Verstärkungsfaktorschätzer 40 kann ferner ausgebildet sein, den Verstärkungsfaktor unter Berücksichtigung statistischer Charakteristiken in dem Verstärkersignal 45 zu korrigieren. Die statistischen Charakteristiken können beispielsweise in einem Histogramm, einem Mittelwert oder einer Varianz hinterlegt sein. Weiterhin kann der Verstärkungsfaktorschätzer 40 ausgebildet sein, die statistischen Charakteristiken zu Korrektur des Verstärkungsfaktors aus einem digitalen Verstärkersignal zu bestimmen.

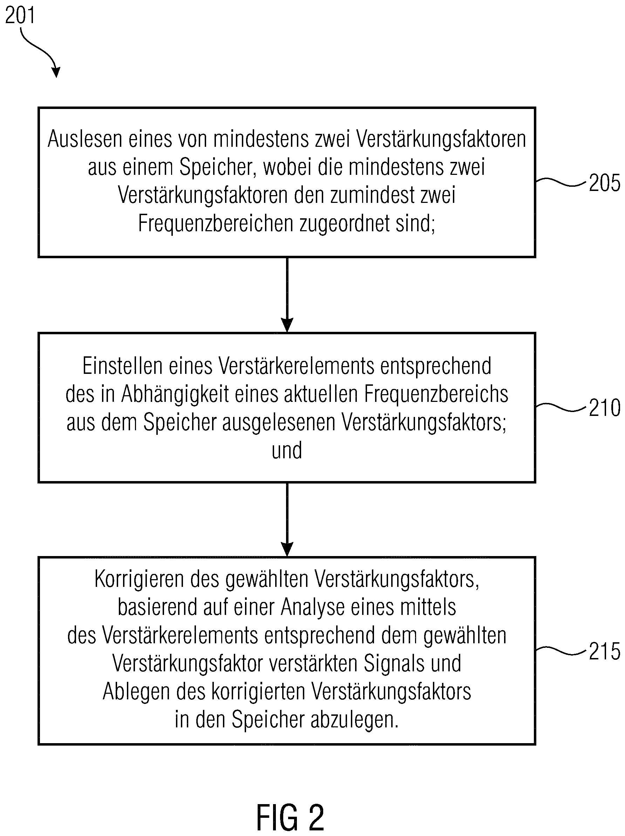

Fig. 2 zeigt ein Flussdiagramm eines Verfahrens 201 zum Betrieb einer Verstärkereinstellvorrichtung 10. Das Verfahren 201 umfasst zumindest die Basisschritte 205 "Auslesen eines von mindestens zwei Verstärkungsfaktoren aus einem Speicher, wobei die mindestens zwei Verstärkungsfaktoren den zumindest zwei Frequenzbereichen zugeordnet sind", 210 "Einstellen eines Verstärkerelements entsprechend des in Abhängigkeit eines aktuellen Frequenzbereichs aus dem Speicher ausgelesenen Verstärkungsfaktors" und 215, "Korrigieren des gewählten Verstärkungsfaktors, basierend auf einer Analyse eines mittels des Verstärkerelements entsprechend dem gewählten Verstärkungsfaktor verstärkten Signals und Ablegen des korrigierten Verstärkungsfaktors in den Speicher abzulegen". Eine Realisierung des Verfahrens kann beispielsweise auf einem Computerprogramm mit einem Programmcode basieren.

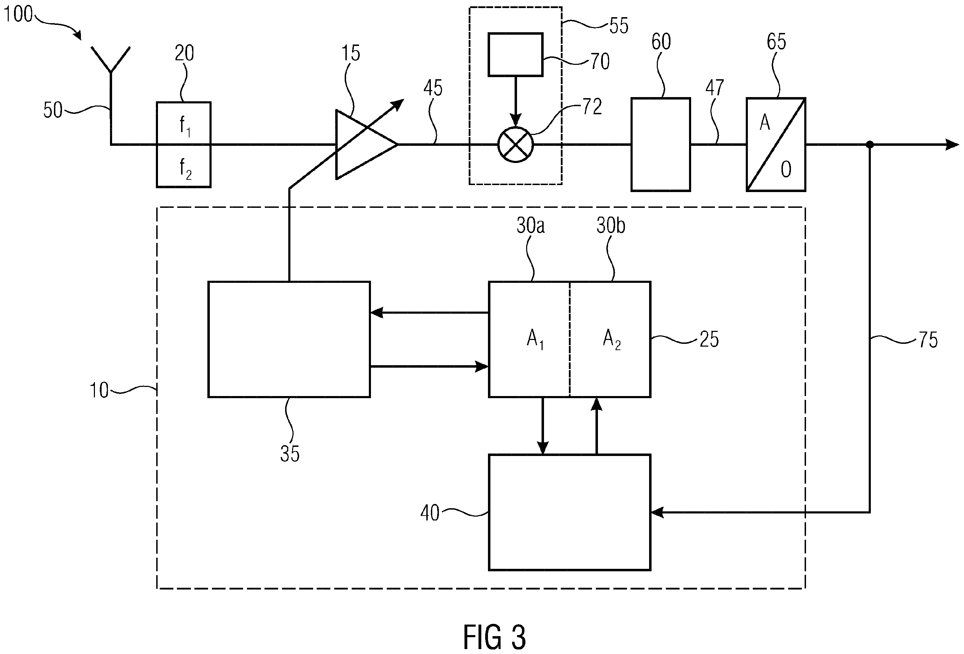

Fig. 3 zeigt einen Signalflussplan einer Verstärkereinstellvorrichtung mit peripheren Bausteinen gemäß eines Ausführungsbeispiels. Die peripheren Baugruppen können beispielsweise eine Antenne 50, das Frequenzbereichsauswahlelement 20, das einstellbare Verstärkerelement 15, einen Mischer 55, einen optionalen Filter 60 und/oder einen Analog-Digital-Wandler 65 umfassen.

Die Antenne 50 kann beispielsweise ein Signal, z.B. eine elektromagnetische Welle empfangen. Die elektromagnetische Welle kann mittels einer elektrischen Verbindung an das Frequenzbereichsauswahlelement 20 übertragen werden. Das Frequenzbereichsauswahlelement 20 kann die elektromagnetische Welle mit einem der zumindest zwei Frequenzbereiche 20a, 20b filtern und so ein erstes Teilsignal in dem ersten Frequenzbereich 20a oder ein zweites Teilsignal in dem zweiten Frequenzbereich 20b isolieren. Das einstellbare Verstärkerelement 15 kann das erste oder das zweite Teilsignal gemäß dem eingestellten Verstärkungsfaktor verstärken und somit das Verstärkersignal 45 erzeugen.

Der Mischer 55 kann einen Oszillator 70, beispielsweise einen Lokaloszillator 70 mit einstellbarer Frequenz und einen Mischer 72, beispielsweise einen Multiplizierer oder Addierer umfassen, der das Verstärkersignal und das Oszillatorsignal mischt, das heißt beide Signale addiert oder multipliziert. Die Modulation kann derart ausgeführt werden, dass das Verstärkersignal aus dem aktuellen Frequenzbereich, z.B. im Bereich von 1GHz bis 5GHz, beispielsweise 3GHz, in einen neuen Frequenzbereich, z.B. im Bereich von 100MHz bis 300MHz, beispielsweise 240MHz, transformiert wird. Die Mittenfrequenz des transformierten Frequenzbereichs kann auf die Mittenfrequenz des Zwischenfrequenzfilters 60 abgestimmt sein. Der Zwischenfrequenzfilter kann ein Filter mit fester Mittenfrequenz sowie fester Bandbreite sein, der bessere Filtercharakteristiken aufweisen kann als das Frequenzbereichsauswahlelement 20. Dies kann durch die Modulation des verstärkten Signals unterstützt werden, wenn das verstärkte Signal in einen Frequenzbereich moduliert ist, in dem eine einfacherer Signalverarbeitung möglich ist, beispielsweise wenn Hochfrequenzeffekte vernachlässigt werden können. Ferner kann der Zwischenfrequenzfilter 60 unerwünschte Frequenzen, beispielsweise nach der Modulation auftretende Spiegelfrequenzen, aus dem modulierten Signal herausfiltern.

Nach dem Zwischenfrequenzfilter 60 kann das resultierende Signal 47 in einem Analog-Digital-Wandler 65 digitalisiert werden. Für eine optimale Umsetzung des analogen in das digitale Signal kann eine gute Aussteuerung des Analog-Digital Wandlers 65 vorteilhaft sein. Der einstellbare Verstärker 15 kann also die minimale und/oder maximale Amplitude des verstärkten Signals über den gewählten Verstärkungsfaktor derart anpassen, dass der Analog-Digital-Wandler optimal ausgesteuert wird.

Zur Analyse des digitalisierten Signals umfasst die Verstärkereinstellvorrichtung 10 den Verstärkungsfaktorschätzer 40. Derselbe kann das digitale Signal 75 analysieren und beispielsweise statistische Parameter, wie z.B. den Mittelwert, den Median, ein Histogramm oder die Varianz aus dem digitalen Signal 75 ermitteln. Aus den statistischen Charakteristiken des digitalen Signals kann ein Korrekturfaktor für den Verstärkungsfaktor 30a oder 30b oder ein optional weiterer Verstärkungsfaktor ermittelt werden.

In dem Speicher 25, der z.B. als Art Lookup-Table (dt.: Umsetzungstabelle), umfassend die Vielzahl der Verstärkungsfaktoren für die Vielzahl der möglichen Frequenzbereiche realisiert sein kann, können ferner neben den aktuellen Verstärkungsfaktoren weitere Verstärkungsfaktoren aus vorherigen Iterationsschritten gespeichert werden. Liegen die Verstärkungsfaktoren aus vorangegangenen Iterationsschritten oder die zu den Verstärkungsfaktoren aus vorangegangenen Iterationsschritten im Speicher 25, so kann der Verstärkungsfaktorschätzer 40 beispielsweise die vorangegangenen Verstärkungsfaktoren oder die Änderung der vorangegangenen Verstärkungsfaktoren in die Bildung des aktuellen Verstärkungsfaktors mit einfließen lassen. Dies kann beispielsweise mittels einer absteigenden Gewichtung der vorangegangenen Verstärkungsfaktoren, das heißt der Verstärkungsfaktor aus dem vorangegangenen Iterationsschritt kann stärker gewichtet werden als ein Verstärkungsfaktor aus einem vorangegangenen Iterationsschritt. Diese Gewichtung kann beispielsweise mittels eines Leaky-Integrators, eines linear gewichteten, gleitenden Mittelwerts oder eines exponentiell geglätteten Mittelwerts erreicht werden.

Ferner kann als Startwert eine maximale Verstärkung gewählt sein. Zu diesem Zeitpunkt können im Speicher keine aktuellen Verstärkungsfaktoren vorliegen. Demnach ist keine gemäß den vorangegangenen Verstärkungsfaktoren gewichtete Anpassung des Verstärkungsfaktors möglich. Dies kann in einen größeren Sprung des Verstärkungsfaktors resultieren, als wenn zu einem späteren Zeitpunkt die vorangegangenen Verstärkungsfaktoren einen glättenden Einfluss auf die Anpassung des Verstärkungsfaktors ausüben können.

Das einstellbare Verstärkerelement 15, kann beispielsweise durch einen Transistor oder eine Transistorstufe realisiert sein. Der Verstärkungsfaktor kann also beispielsweise ein digitaler Wert sein, welchem eine Bias-Spannung für das Verstärkerelement 15 zugeordnet ist. Die Auswahl des aktuellen Frequenzbereichs wird mittels eines Frequenzbereichseinstellelements vorgenommen. Dasselbe kann den Frequenzbereich im Frequenzbereichsauswahlelement 20, die Oszillationsfrequenz des Lokaloszillators 70 sowie den aktuellen Frequenzbereich im Verstärkungsfaktoreinstellelement 35 vorgeben. Somit kann eine Synchronisation der Verstärkungsfaktoren gewährleistet sein.

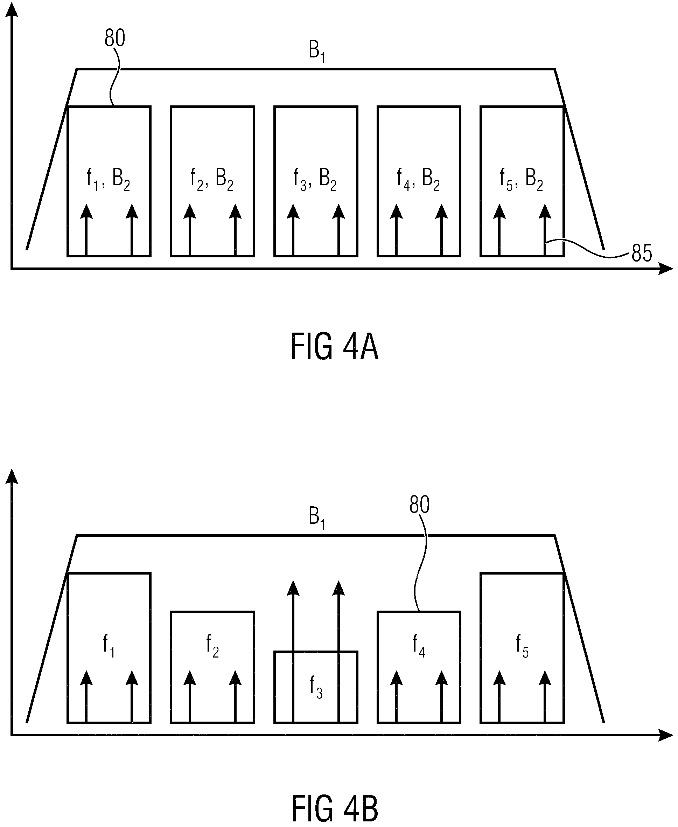

Fig. 4a und Fig. 4b zeigen schematische Diagramme in einer Frequenzdarstellung, die einen Frequenzbereich B1 darstellen, der in fünf Frequenzbereiche 80 aufgeteilt ist. In diesen Diagrammen wird jeder Frequenzbereich 80 mit einer Mittenfrequenz f1-f5, sowie einer Bandbreite B2 charakterisiert. Die Mittenfrequenz f1 und f2 kann den zumindest zwei Frequenzbereichen 20a und 20b entsprechen. Ferner können die Frequenzbereiche mit der Mittenfrequenz f3 bis f5 weitere Frequenzbereiche charakterisieren, so dass beispielsweise ein Frequenzbereichsauswahlelement mit einer Filterbank von fünf Filtern ein derartiges Ergebnis erzeugen kann. Die Bandbreite B1 kann dem Arbeitsbereich der Verstärkereinstellvorrichtung 10 entsprechen. Innerhalb der Frequenzbänder 80 deuten die Pfeile 85 schematisch die Stärke der im Frequenzbereich enthaltenen Frequenzen an.

In Fig. 4a weisen die Pfeile durchgehend eine ähnliche Länge auf, wodurch in diesem Schema keine charakteristischen auftretenden Frequenzen in einem Frequenzband vorliegen. Die Verstärkung kann in allen Frequenzbereichen gleich sein, beispielsweise kann die maximal mögliche Verstärkung gewählt werden. Die Verstärkung kann jedoch so angepasst werden, dass eine Übersteuerung des Analog-Digital Wandlers vermieden wird. Die Anpassung kann über die Verstärkereinstellvorrichtung erfolgen, die beispielsweise das digitale Signal nach dem Analog-Digital Wandler analysiert und die Verstärkung bzw. den Verstärkungsfaktor erhöht, wenn der Analog-Digital Wandler unter seinem optimalen Aussteuerbereich betrieben wird, und dieselbe verringert, wenn der Analog-Digital Wandler über seinem optimalen Aussteuerbereich betrieben wird. Die Korrektur kann, wie bereits beschrieben, dynamisch durch die Verstärkereinstellvorrichtung erfolgen.

Fig. 4b zeigt im Frequenzbereich der Mittenfrequenz f3 eine Häufung charakteristischer Frequenzen, die durch lange Pfeile 85 beschrieben sind. Hier kann es vorteilhaft sein, nicht nur den Frequenzbereich um die Mittenfrequenz f3, sondern auch die angrenzenden Frequenzbereiche weniger stark zu verstärken. Dies kann im Auftreten von Nichtlinearitäten in den analogen Stufen, beispielsweise dem Mischer, dem Zwischenfrequenzfilter oder dem Analog-Digital-Wandler begründet sein. Beispielsweise können unerwünschte Intermodulationsprodukte in einem Frequenzbereich in die benachbarten Frequenzbereiche übersprechen. Werden für angrenzende Frequenzbereiche sich stark unterscheidende Verstärkungsfaktoren angewendet, so können auch die Intermodulationsprodukte im Vergleich zum Nutzsignal überproportional verstärkt werden. Daher kann der Verstärkungsfaktorschätzer ausgebildet sein, die mindestens zwei Verstärkungsfaktoren, die zwei aufeinanderfolgenden Frequenzbereichen zugeordnet sind, maximal um einen vorgegeben Faktor zu verändern.

Ferner kann durch die Nichtlinearitäten, z.B. bei hohen Eingangsleistungen, sog. Blocking (Kompression) entstehen, wenn die gesamte Signalenergie im Arbeitsbereich der Verstärkereinstellvorrichtung einen anwendungsabhängigen Grenzwert überschreitet. Um dem Blocking entgegenzuwirken, kann der Verstärkungsfaktorschätzer ausgebildet sein, die mindestens zwei Verstärkungsfaktoren auf ein vorgegebenes Vielfaches eines Verstärkungsfaktors eines Teilsignals mit der größten Signalleistung zu begrenzen.

Eine typischerweise in Empfängern vorhandene Vorselektion aus analogen Bandpassfiltern (meistens realisiert als eine Filterbank mit festfrequenten oder durchstimmbaren Filtern) kann dazu dienen, die Signalenergie bereits möglichst weit vor dem eigentlichen Zwischenfrequenzfilter zu reduzieren. Ein Empfänger kann beispielsweise einen Antenneneingang, ein analoges Filter (pre selector, dt.: Vorauswahlelement) mit einer Bandbreite B1, eine Stufe mit einstellbarer Verstärkung, einen Frequenzumsetzer (z.B. schwach nicht-linear), einen Zwischenfrequenzfilter mit der Bandbreite B2 und einen Analog-Digital-Wandler umfassen. Dabei ist die Bandbreite B1 in der Regel deutlich größer als die Bandbreite B2. Im Beispiel der Figuren 4a und 4b wird B1 = 5*B2 gewählt. Es kann weiterhin vereinfachend angenommen werden, dass die Bandbreite B2 durch fünf Segmente mit den Mittenfrequenzen f1-f5 abgedeckt wird. Ist die Bandbreite B2 in allen Segmenten nur mit schwachen Signalen belegt, so kann in jedem Segment die maximal verfügbare Verstärkung gewählt werden (siehe Fig. 4a).

Neben der Aussteuerung des Analog-Digital Wandlers (die nur durch die Verstärkung innerhalb des aktiven Segments bestimmt wird) können auch Nichtlinearitäten in den davor befindlichen analogen Stufen das Großsignalverhalten des Empfängers bestimmen, vornehmlich durch Intermodulationsprodukte zweiter und dritter Ordnung, aber auch durch Blocking (Kompression) bei sehr hohen Eingangsleistungen. Daraus lassen sich folgende Bedingungen für die Wahl einer geeigneten Verstärkung ableiten.

Blocking kann auftreten, wenn die gesamte Signalenergie innerhalb von B1 zu groß wird. Die spektrale Verteilung ist erst in zweiter Linie maßgeblich. Somit darf in keinem Segment innerhalb von B1 die Verstärkung jedes Segmentes mit der größen Signalleistung um mehr als einem bestimmten Faktor übersteigen. Dieser Faktor ist abhängig von der konkreten Realisierung.

Intermodulationen dritter Ordnung treten in der Regel auf, bevor Blocking erkennbar ist. Dabei kann angenommen werden, dass die intermodulierenden Signale innerhalb eines Segmentes (z.B. f3 in Fig. 4b) liegen können. Somit können die Intermodulationsprodukte dritter Ordnung jeweils in die benachbarten Segmente (also f2 und f4) fallen (vgl. Fig. 4b). Dementsprechend darf sich zwischen benachbarten Segmenten die Verstärkung nicht zu stark ändern.

Eine zu große Verstärkung in einem Segment mit niedriger Signalleistung kann somit zu einer Verschlechterung der Empfangsqualität führen, da die Vorstufe durch starke Signale in anderen Segmenten innerhalb von B2 übersteuert werden kann. Durch Verknüpfen der Messwerte mehrerer Segmente und Erkenntnis der im Empfänger gegebenenfalls vorhandenen analogen Filter lassen sich die zu erwartenden Intermodulationsprodukte voraussagen. Gegebenenfalls kann die Verstärkung im momentan aktiven betroffenen Segment abgesenkt werden.

Ergänzend zu Fig. 1 sei angemerkt, dass die Vorrichtung 10 in Kombination mit dem Signalverstärkungspfad 12 ein System bildet, dass ausgebildet ist, ein beispielsweise hochfrequentes Signal zu verstärken, wobei der Verstärkungsfaktor von der Vorrichtung 10 berechnet wird.

Die vorliegende Erfindung kann Anwendung bei Hochfrequenzempfängern finden, die schnell einen bezogen auf ihre Echtzeitbandbreite großen Frequenzbereich nach Signalen absuchen sollen. Das Absuchen kann dadurch erfolgen, dass die Mittenfrequenz des Empfängers in schneller Folge umgeschaltet wird und bei jeder Frequenz eine Anzahl von Leitungsdichtespektren aufgenommen werden kann (Scan). Hier kann es insbesondere vorteilhaft sein, eine geeignete Einstellung für die Verstärkung zwischen Antenneneingang und Analog-Digital-Umsetzer zu finden, die den Analog-Digital-Umsetzer optimal aussteuert und über Steuerungen im Analog-Digital-Umsetzer oder dem davor befindlichen Analogteil sicher vermeidet. Je nach eingestellter Mittenfrequenz kann die optimale Verstärkung im Regelfall unterschiedlich sein und auch über die Zeit schwanken. Bei hinreichend großer Echtzeitbandbreite des Empfängers können, beispielsweise bei stationärem Einsatz, die frequenzabhängigen Schwankungen deutlich größer sein als die zeitabhängigen Schwankungen. Mit obigem Konzept wird kann eine optimale Einstellung der Verstärkung eines solchen Empfängers ermöglicht, ohne die Zeit zu verlängern, die für einen Scan benötigt wird. Mit anderen Worten schaffen Ausführungsbeispiele für jede Mittenfrequenz oder wenigstens zwei Segmente des Scanbereichs je ein Gedächtnis (z.B. einen Speicher) vorzuhalten, welches die für diesen Frequenzbereich optimale Verstärkung enthält. Mit jedem Sweep (dt.: Iteration) wird es aktualisiert. Das Gedächtnis kann vorzugsweise nicht nur als Mittelwert gehalten werden, sondern auch Informationen über die statistische Verteilung (z.B. Histogramm, Mittelwert und Varianz etc.) enthalten. Die Messgröße kann die innerhalb eines Zeitintervalls maximale Aussteuerung des Analog-Digital Wandlers sein.

Entsprechend alternativer Ausführungsbeispiele kann die Wirkung eines Messwerts auf das Gedächtnis mit der Zeit abnehmen, was durch gleitende Mittelung oder eine rückgekoppelte Struktur (z.B. einen Leaky-Integrator) erreicht werden kann. Aus dem Mittelwert und, sofern vorhanden, der statistischen Verteilung, kann die, für den aktuellen Sweep und die aktuell eingestellte Frequenz, optimale Verstärkung ermittelt und eingestellt werden.

Weitere Ausführungsbeispiele zeigen die Verstärkereinstellvorrichtung gemäß einem der vorherigen Ansprüche, wobei die mindestens zwei Verstärkungsfaktoren 30a, 30b Stützstellen in Frequenz und Zeit für eine Interpolationsfunktion sind, mit derselben das einstellbare Verstärkerelement 15 eingestellt wird. Die Stützstellen des Verstärkungsfaktors (bzw. der Aussteuerung, da beides ineinander umrechenbar ist), basieren auf den Messungen des Verstärkungsfaktorschätzers 40 (der auch als Schätzer für die Aussteuerung betrachtet werden kann). Die mathematische Interpolationsfunktion, die durch die Stützstellen gelegt wird, ist beispielsweise ein Regressions-Polynom, ein Regressions-Polynomzug (Regressions-Spline) oder ein erzwungene kubische Funktion (Constrained Cubical). Durch Parametrierung der Interpolationsfunktion erreicht man, dass die gewünschten und bereits beschriebenen Randbedingungen (z. B. keine starken Sprünge in der Verstärkung zwischen benachbarten Frequenzabschnitten) berücksichtigt werden. Ferner können alte Stützstellen gelöscht werden, wenn sich innerhalb eines Frequenzabschnitts genügend Stützstellen befinden. Der Vorteil dieses Ausführungsbeispiels liegt darin begründet, dass es unabhängig von einem festen Frequenzraster ist. Somit liegt bereits ein initialer Wert für eine Verstärkung bzw. Aussteuerung vor, selbst wenn bei genau dieser Frequenz noch kein Messwert für die Aussteuerung vorliegt, da diese Frequenz noch nicht eingestellt war.

Gemäß einem bevorzugten Ausführungsbeispiel sind das Verstärkereinstellelement sowie die zugehörigen Komponenten umschaltbar ausgelegt, so dass in einem Durchlauf bzw. einer Iteration (Sweep) Frequenzbereiche in einem Frequenzband nach auftretenden oder vorliegenden Signalen bzw. Signalanteilen abgesucht werden können. Eine Iteration beschreibt hier einen (vollständigen) Durchlauf des Frequenzbandes bzw. einen Durchlauf (aller) in dem Frequenzband definierten Frequenzbereiche. So kann in einem ersten Schritt ein erster Frequenzbereich abgesucht bzw. gescannt werden, so dass in dem Frequenzbereich vorliegende Signalanteile empfangen und gemäß dem gespeicherten zugehörigen Verstärkungsfaktor verstärkt werden. Während bereits ein zweiter Frequenzbereich, der sich vorteilhafterweise von dem ersten Frequenzbereich unterscheidet, abgesucht wird, kann das verstärkte erste Signal analysiert werden. Zum Beispiel basierend auf einer Aussteuerung eines optionalen Analog-Digital-Wandlers kann der Verstärkungsfaktor korrigiert werden und derart korrigiert bzw. angepasst im Speicher abgelegt werden. Parallel dazu kann ein Signalanteil in dem zweiten abgesuchten Frequenzbereich empfangen und verstärkt worden sein. Während ein weiterer Frequenzbereich oder erneut der erste Frequenzbereich abgesucht wird, kann auch für den zweiten Frequenzbereich das verstärkte Signal analysiert und basierend auf dem analysierten Signal der Verstärkungsfaktor korrigiert und im Speicher abgelegt werden. Liegen keine weiteren Frequenzbereiche vor oder sind alle Frequenzbereiche gescannt, wird das während des Korrigierens des zweiten oder des vorherigen Verstärkungsfaktors empfangene Teilsignal aus dem ersten Frequenzbereich mit dem zweifach korrigierten Verstärkungsfaktor, der nach der vorigen Messung des verstärkten Teilsignals aus dem ersten Frequenzbereich abgespeichert wurde, verstärkt. Wiederum wird das nun mit dem zweifach korrigierten Verstärkungsfaktor verstärkte Signal analysiert und der zweifach korrigierte Verstärkungsfaktor basierend auf dem analysierten Signal angepasst und ein dreifach korrigierter Verstärkungsfaktor im Speicher abgelegt.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparats), wie zum Beispiel einen Mikroprozessor, einen programmierbaren Computer oder eine elektronische Schaltung ausgeführt werden. Bei einigen Ausführungsbeispielen können einige oder mehrere der wichtigsten Verfahrensschritte durch einen solchen Apparat ausgeführt werden.

Je nach bestimmten Implementierungsanforderungen können Ausführungsbeispiele der Erfindung in Hardware oder in Software implementiert sein. Die Implementierung kann unter Verwendung eines digitalen Speichermediums, beispielsweise einer Floppy-Disk, einer DVD, einer Blu-ray Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein.

Manche Ausführungsbeispiele gemäß der Erfindung umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft.

Der Programmcode kann beispielsweise auch auf einem maschinenlesbaren Träger gespeichert sein.

Andere Ausführungsbeispiele umfassen das Computerprogramm zum Durchführen eines der hierin beschriebenen Verfahren, wobei das Computerprogramm auf einem maschinenlesbaren Träger gespeichert ist.

Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft.

Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren aufgezeichnet ist.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Ein weiteres Ausführungsbeispiel gemäß der Erfindung umfasst eine Vorrichtung oder ein System, die bzw. das ausgelegt ist, um ein Computerprogramm zur Durchführung zumindest eines der hierin beschriebenen Verfahren zu einem Empfänger zu übertragen. Die Übertragung kann beispielsweise elektronisch oder optisch erfolgen. Der Empfänger kann beispielsweise ein Computer, ein Mobilgerät, ein Speichergerät oder eine ähnliche Vorrichtung sein. Die Vorrichtung oder das System kann beispielsweise einen Datei-Server zur Übertragung des Computerprogramms zu dem Empfänger umfassen.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Hochfrequenzempfänger zum Absuchen eines Frequenzbandes mit mindestens zwei Frequenzbereichen (20a, 20b) wobei zum Absuchen des Frequenzbandes zwischen den mindestens zwei Frequenzbereichen umgeschaltet wird; umfassend eine Verstärkereinstellvorrichtung (10) für ein in Abhängigkeit von einem Verstärkungsfaktor (30a, 30b) einstellbares Verstärkerelement (15), das mit einem Frequenzbereichsauswahlelement (20) zur Einstellung von zumindest zwei Frequenzbereichen (20a, 20b) gekoppelt ist, mit folgenden Merkmalen:
einem Speicher (25), in dem mindestens zwei Verstärkungsfaktoren (30a, 30b) hinterlegbar sind, wobei die mindestens zwei Verstärkungsfaktoren (30a, 30b) den zumindest zwei Frequenzbereichen (20a, 20b) zugeordnet sind;
einem Verstärkungsfaktoreinstellelement (35), das ausgebildet ist, in Abhängigkeit eines aktuellen Frequenzbereichs einen entsprechenden Verstärkungsfaktor (30a, 30b) aus dem Speicher (25) auszuwählen, um so das einstellbare Verstärkerelement (15) für den aktuellen Frequenzbereich einzustellen; und
einem Verstärkungsfaktorschätzer (40), der ausgebildet ist, basierend auf einer Analyse eines mittels des einstellbaren Verstärkerelements (15) entsprechend dem gewählten Verstärkungsfaktor verstärkten Signals den gewählten Verstärkungsfaktor (40) zu korrigieren und den korrigierten Verstärkungsfaktor (30a, 30b) in dem Speicher (25) abzulegen;
wobei zur Korrektur der Verstärkungsfaktoren für die aktuellen Frequenzbereiche in jeder Iteration angepasste Korrekturfaktoren berechnet werden.

2. Hochfrequenzempfänger (10) gemäß Anspruch 1, wobei der Verstärkungsfaktorschätzer (40) ausgebildet ist, um den korrigierten Verstärkungsfaktor (30a, 30b) je nach aktuellem Frequenzbereich in einer weiteren Iteration zu korrigieren, um einen zweifach korrigierten Verstärkungsfaktor (30a, 30b) zu erhalten.

3. Hochfrequenzempfänger gemäß einem der vorherigen Ansprüche, wobei die Frequenzbereiche des Hochfrequenzempfängers in einer Iteration in schneller Folge umgeschaltet werden, um jeden Frequenzbereich des Frequenzbands nach Signalen abzusuchen.

4. Hochfrequenzempfänger gemäß einem der vorherigen Ansprüche, wobei das Verstärkungsfaktoreinstellelement ausgebildet ist, für benachbarte Frequenzbereiche sich unterscheidende Verstärkungsfaktoren aus dem Speicher auszuwählen, um den sich ändernden Signalstärken gerecht zu werden.

5. Hochfrequenzempfänger gemäß einem der vorherigen Ansprüche, wobei der Verstärkungsfaktorschätzer ausgebildet ist, die verstärkten Signale aus den Frequenzbereichen sequentiell zu analysieren und den korrigierten Verstärkungsfaktor ein verstärktes Signal aus dem ersten Frequenzbereich zu berechnen, wobei das einstellbare Verstärkerelement ausgebildet ist, während der Analyse ein Signal aus dem zweiten Frequenzbereich zu verstärken.

6. Hochfrequenzempfänger (10) gemäß einem der vorherigen Ansprüche, wobei der Verstärkungsfaktorschätzer (40) ausgebildet ist, den Verstärkungsfaktor (30a, 30b) unter Berücksichtigung statistischer Charakteristiken in dem mit dem gewählten Verstärkungsfaktor (30a, 30b) verstärkten Signal (45) zu korrigieren.

7. Hochfrequenzempfänger (10) gemäß einem der vorherigen Ansprüche, wobei der Verstärkungsfaktorschätzer (40) ausgebildet ist, einen Verstärkungsfaktor (30a, 30b) aus dem Speicher (25) auszulesen, zu korrigieren und einen korrigierten Verstärkungsfaktor (30a, 30b) in den Speicher (25) abzulegen.

8. Hochfrequenzempfänger (10) gemäß einem der vorherigen Ansprüche, wobei der Verstärkungsfaktorschätzer (40) ausgebildet ist, die mindestens zwei Verstärkungsfaktoren (30a, 30b), die zwei aufeinanderfolgenden Frequenzbereichen (20a, 20b) zugeordnet sind, um einen vorgegebenen Faktor zu verändern.

9. Hochfrequenzempfänger (10) gemäß einem der vorherigen Ansprüche, wobei der Verstärkungsfaktorschätzer (40) ausgebildet ist, die mindestens zwei Verstärkungsfaktoren (30a, 30b) auf ein vorgegebenes Vielfaches eines Verstärkungsfaktors eines Teilsignals mit der größten Signalleistung zu begrenzen.

10. Hochfrequenzempfänger (10) gemäß einem der vorherigen Ansprüche, wobei die mindestens zwei Verstärkungsfaktoren (30a, 30b) Stützstellen in Frequenz und Zeit für eine Interpolationsfunktion sind, mit derselben das einstellbare Verstärkerelement (15) eingestellt wird.

11. System (100), welches einen Hochfrequenzempfänger (10) gemäß einem der Ansprüche 1-10, ein Frequenzbereichsauswahlelement (20) und ein einstellbares Verstärkerelement (15) umfasst,
wobei das Frequenzbereichsauswahlelement (20) ein Signal in ein erstes Teilsignal in einem ersten Frequenzbereich (20a) und ein zweites Teilsignal in einem zweiten Frequenzbereich (20b) teilt,
wobei die Verstärkereinstellvorrichtung (10) das erste oder das zweite Teilsignal entsprechend des Verstärkungsfaktors (30a, 30b) verstärkt,
wobei die Verstärkereinstellvorrichtung (10) mit dem einstellbaren Verstärkerelement (15) gekoppelt ist, um dasselbe mit dem Verstärkungsfaktor (30a) oder (30b) gemäß des vom Frequenzbereichsauswahlelement (20) ausgewählten Frequenzbereichs (20a, 20b) einzustellen.

12. System (100) gemäß Anspruch 11, wobei das Frequenzbereichsauswahlelement (20) ausgebildet ist, um alternierend den ersten und zweiten Frequenzbereich (20a, 20b) auszuwählen.

13. System (100) gemäß einem der Ansprüche 11-12, wobei das System einen Analog-Digital Wandler (65) umfasst, der ausgebildet ist, das entsprechend dem gewählten Verstärkungsfaktor verstärkte Signal (45) zu digitalisieren,
wobei der Verstärkungsfaktor (30a, 30b) derart gewählt ist, dass der Verstärkungsfaktor (30a, 30b) nach unten korrigiert wird, wenn der Analog-Digital Wandler (65) übersteuert und nach oben korrigiert wird, wenn der Analog-Digital Wandler (65) untersteuert.

14. Verfahren zum Betrieb eines Hochfrequenzempfängers zum Absuchen eines Frequenzbandes mit mindestens zwei Frequenzbereichen (20a, 20b), wobei zum Absuchen des Frequenzbandes zwischen den mindestens zwei Frequenzbereichen umgeschaltet wird, umfassend eine Verstärkereinstellvorrichtung (10) mit
einem in Abhängigkeit von einem Verstärkungsfaktor (30a, 30b) einstellbaren Verstärkerelement (15), das mit einem Frequenzbereichsauswahlelement (20) zur Einstellung von zumindest zwei Frequenzbereichen (20a, 20b) gekoppelt ist, wobei der Betrieb **gekennzeichnet ist durch**
Bereitstellen von mindestens zwei Verstärkungsfaktoren (30a, 30b) in einem Speicher (25), wobei die mindestens zwei Verstärkungsfaktoren (30a, 30b) den zumindest zwei Frequenzbereichen (20a, 20b) zugeordnet sind;
Einstellen eines einstellbaren Verstärkerelements (15) entsprechend des in Abhängigkeit eines aktuellen Frequenzbereichs aus dem Speicher (25) ausgewählten Verstärkungsfaktors (30a, 30b) für den aktuellen Frequenzbereich; und
Korrigieren des gewählten Verstärkungsfaktors (30a, 30b), basierend auf einer Analyse eines mittels des einstellbaren Verstärkerelements (15) entsprechend dem gewählten Verstärkungsfaktor (30a, 30b) verstärkten Signals (45) und Ablegen des korrigierten Verstärkungsfaktors (30a, 30b) in den Speicher (25);
wobei zur Korrektur der Verstärkungsfaktoren für die aktuellen Frequenzbereiche in jeder Iteration angepasste Korrekturfaktoren berechnet werden.

15. Computerprogramm mit einem Programmcode, wobei der Programmcode gemäß dem Verfahren aus Anspruch 14 ausgebildet ist.

## Claims

1. High-frequency receiver for searching a frequency band with at least two frequency domains (20a, 20b), wherein searching the frequency band comprises switching between the at least two frequency domains; including an amplifier adjusting device (10) for an amplifier element (15) which is adjustable as a function of an amplification factor (30a, 30b) and is coupled to a frequency domain selecting element (20) for adjusting at least two frequency domains (20a, 20b), comprising:
a memory (25) in which at least two amplification factors (30a, 30b) may be stored, said at least two amplification factors (30a, 30b) being assigned to the at least two frequency domains (20a, 20b);
an amplification factor adjusting element (35) configured to select, depending on a current frequency domain, a corresponding amplification factor (30a, 30b) from the memory (25) in order to adjust the adjustable amplifier element (15) for the current frequency domain; and
an amplification factor estimator (40) configured to correct, based on an analysis of a signal amplified by means of the adjustable amplifier element (15) in accordance with the selected amplification factor, the selected amplification factor (40) and to store the corrected amplification factor (30a, 30b) in the memory (25);
wherein correcting the amplification factors for the current frequency domains comprises calculating correction factors adapted in each iteration.

2. High-frequency receiver (10) according to claim 1, wherein the amplification factor estimator (40) is configured to correct the corrected amplification factor (30a, 30b) in accordance with a current frequency domain in a further iteration in order to obtain an amplification factor (30a, 30b) corrected twice.

3. High-frequency receiver according to any of the preceding claims, wherein the frequency domains of the high-frequency receiver are switched in rapid succession in an iteration in order to search each frequency domain of the frequency band for signals.

4. High-frequency receiver according to any of the preceding claims, wherein the amplification factor adjusting element is configured to select differing amplification factors from the memory for neighbouring frequency domains in order to satisfy the changing signal strengths.

5. High-frequency receiver according to any of the preceding claims, wherein the amplification factor estimator is configured to sequentially analyze the amplified signals from the frequency domains and to calculate the corrected amplification factor for an amplified signal from the first frequency domain, the adjustable amplifier element being configured to amplify a signal from the second frequency domain during the analysis.

6. High-frequency receiver (10) according to any of the preceding claims, wherein the amplification factor estimator (40) is configured to correct the amplification factor (30a, 30b) in consideration of statistical characteristics in the signal (45) amplified with the selected amplification factor (30a, 30b).

7. High-frequency receiver (10) according to any of the preceding claims, wherein the amplification factor estimator (40) is configured to read out an amplification factor (30a, 30b) from the memory (25), to correct the same and to store a corrected amplification factor (30a, 30b) in the memory (25).

8. High-frequency receiver (10) according to any of the preceding claims, wherein the amplification factor estimator (40) is configured to change the at least two amplification factors (30a, 30b) assigned to two subsequent frequency domains (20a, 20b) by a preset factor.

9. High-frequency receiver (10) according to any of the preceding claims, wherein the amplification factor estimator (40) is configured to limit the at least two amplification factors (30a, 30b) to a preset multiple of an amplification factor of a sub-signal with the largest signal power.

10. High-frequency receiver (10) according to any of the preceding claims, wherein the at least two amplification factors (30a, 30b) are support points in terms of frequency and time for an interpolation function with which the adjustable amplifier element (15) is adjusted.

11. System (100) including a high-frequency receiver (10) according to any of claims 1 to 10, a frequency domain selecting element (20) and an adjustable amplifier element (15),
wherein the frequency domain selecting element (20) divides a signal into a first sub-signal in a first frequency domain (20a) and into a second sub-signal in a second frequency domain (20b),
wherein the amplifier adjusting device (10) amplifies the first or the second sub-signal in accordance with the amplification factor (30a, 30b),
wherein the amplifier adjusting device (10) is coupled to the adjustable amplifier element (15) in order to adjust the same with the amplification factor (30a, 30b) in accordance with the frequency domain (20a, 20b) selected by the frequency domain selecting element (20).

12. System (100) according to claim 11, wherein the frequency domain selecting element (20) is configured to select the first and second frequency domains (20a, 20b) in an alternating manner.

13. System (100) according to any of claims 11 to 12, wherein the system includes an analog-digital converter (65) configured to digitalize the signal (45) amplified in accordance with the selected amplification factor,
wherein the amplification factor (30a, 30b) is selected such that the amplification factor (30a, 30b) is corrected downwards when the analog-digital converter (65) overdrives, and is corrected upwards when the analog-digital converter (65) underdrives.

14. Method for operating a high-frequency receiver for searching a frequency band with at least two frequency domains (20a, 20b), wherein searching the frequency band comprises switching between the at least two frequency domains, including an amplifier adjusting device (10) with
an amplifier element (15) which is adjustable as a function of an amplification factor (30a, 30b) and is coupled to a frequency domain selecting element (20) for adjusting at least two frequency domains (20a, 20b), the operation being **characterized by**
providing at least two amplification factors (30a, 30b) in a memory (25), said at least two amplification factors (30a, 30b) being assigned to the at least two frequency domains (20a, 20b);
adjusting an adjustable amplifier element (15) in accordance with the amplification factor (30a, 30b) selected from the memory (25) depending on a current frequency domain for the current frequency domain; and
correcting the selected amplification factor (30a, 30b) based on an analysis of a signal (45) amplified by means of the adjustable amplifier element (15) in accordance with the selected amplification factor (30a, 30b), and storing the corrected amplification factor (30a, 30b) in the memory (25);
wherein correcting the amplification factors for the current frequency domains comprises calculating correction factors adapted in each iteration.

15. Computer program comprising a program code, wherein the program code is configured according to the method of claim 14.

## Revendications

1. Récepteur de hautes fréquences destiné à balayer une bande de fréquences avec au moins deux plages de fréquences (20a, 20b), dans lequel il est commuté, pour balayer la bande de fréquences, entre les au moins deux plages de fréquences; comportant un dispositif de réglage d'amplificateur (10) pour un élément amplificateur (15) réglable en fonction d'un facteur d'amplification (30a, 30b) qui est couplé à un élément de sélection de plage de fréquences (20) pour régler au moins deux plages de fréquences (20a, 20b), aux caractéristiques suivantes:
une mémoire (25) dans laquelle peuvent être mémorisés au moins deux facteurs d'amplification (30a, 30b), où les au moins deux facteurs d'amplification (30a, 30b) sont associés aux au moins deux plages de fréquences (20a, 20b);
un élément de réglage de facteur d'amplification (35) qui est conçu pour sélectionner dans la mémoire (25), en fonction d'une plage de fréquences actuelle, un facteur d'amplification correspondant (30a, 30b), pour régler ainsi l'élément amplificateur réglable (15) pour la plage de fréquences actuelle; et
un estimateur de facteur d'amplification (40) qui est conçu pour corriger, sur base d'une analyse d'un signal amplifié au moyen de l'élément amplificateur réglable (15) selon le facteur d'amplification sélectionné, le facteur d'amplification sélectionné (40) et pour mémoriser le facteur de gain corrigé (30a, 30b) dans la mémoire (25);
dans lequel sont calculés, pour la correction des facteurs d'amplification pour les plages de fréquences actuelles, à chaque itération des facteurs de correction adaptés.

2. Récepteur de hautes fréquences (10) selon la revendication 1, dans lequel l'estimateur de facteur d'amplification (40) est conçu pour corriger, dans une autre itération, le facteur d'amplification corrigé (30a, 30b) selon la plage de fréquences actuelle pour obtenir un facteur d'amplification corrigé deux fois (30a, 30b).

3. Récepteur de hautes fréquences selon l'une des revendications précédentes, dans lequel les plages de fréquences du récepteur de hautes fréquences sont commutées, dans une itération, en séquence rapide pour balayer des signaux dans chaque plage de fréquences de la bande de fréquences.

4. Récepteur de hautes fréquences selon l'une des revendications précédentes, dans lequel l'élément de réglage de facteur d'amplification est conçu pour sélectionner dans la mémoire, pour des plages de fréquences adjacentes, des facteurs d'amplification différents, pour tenir compte des intensités de signal changeantes.

5. Récepteur de hautes fréquences selon l'une des revendications précédentes, dans lequel l'estimateur de facteur d'amplification est conçu pour analyser en séquence les signaux amplifiés des plages de fréquences et pour calculer le facteur d'amplification corrigé d'un signal amplifié de la première plage de fréquences, dans lequel l'élément amplificateur réglable est conçu pour amplifier, pendant l'analyse, un signal de la deuxième plage de fréquences.

6. Récepteur de hautes fréquences (10) selon l'une des revendications précédentes, dans lequel l'estimateur de facteur d'amplification (40) est conçu pour corriger le facteur d'amplification (30a, 30b) en tenant compte des caractéristiques statistiques dans le signal (45) amplifié par le facteur d'amplification sélectionné (30a, 30b).

7. Récepteur de hautes fréquences (10) selon l'une des revendications précédentes, dans lequel l'estimateur de facteur d'amplification (40) est conçu pour lire un facteur d'amplification (30a, 30b) dans la mémoire (25), le corriger et pour mémoriser un facteur d'amplification corrigé (30a, 30b) dans la mémoire (25).

8. Récepteur de hautes fréquences (10) selon l'une des revendications précédentes, dans lequel l'estimateur de facteur d'amplification (40) est conçu pour modifier les au moins deux facteurs d'amplification (30a, 30b) qui sont associés à deux plages de fréquences successives (20a, 20b) d'un facteur prédéterminé.

9. Récepteur de hautes fréquences (10) selon l'une des revendications précédentes, dans lequel l'estimateur de facteur d'amplification (40) est conçu pour limiter les au moins deux facteurs d'amplification (30a, 30b) à un multiple prédéterminé d'un facteur d'amplification d'un signal partiel à la puissance de signal la plus grande.

10. Récepteur de hautes fréquences (10) selon l'une des revendications précédentes, dans lequel les au moins deux facteurs d'amplification (30a, 30b) sont des points de support en fréquence et en temps pour une fonction d'interpolation par laquelle est réglé l'élément d'amplificateur réglable (15).

11. Système (100) comportant un récepteur de hautes fréquences (10) selon l'une des revendications 1 à 10, un élément de sélection de plage de fréquences (20) et un élément amplificateur réglable (15),
dans lequel l'élément sélecteur de plage de fréquences (20) divise un signal en un premier signal partiel dans une première plage de fréquences (20a) et un deuxième signal partiel dans une deuxième plage de fréquences (20b),
dans lequel le dispositif de réglage d'amplificateur (10) amplifie le premier ou le deuxième signal partiel selon le facteur d'amplification (30a, 30b),
dans lequel le dispositif de réglage d'amplificateur (10) est couplé à l'élément amplificateur réglable (15), pour régler ce dernier par le facteur d'amplification (30a) ou (30b) selon la plage de fréquences (20a, 20b) sélectionnée par l'élément de sélection de plage de fréquences (20).

12. Système (100) selon la revendication 11, dans lequel l'élément de sélection de plage de fréquences (20) est conçu pour sélectionner en alternance la première et la deuxième plage de fréquences (20a, 20b).

13. Système (100) selon l'une des revendications 11 à 12, dans lequel le système comporte un convertisseur analogique-numérique (85) qui est conçu pour numériser le signal amplifié (45) selon le facteur d'amplification sélectionné,
dans lequel le facteur d'amplification (30a, 30b) est sélectionné de sorte que le facteur d'amplification (30a, 30b) soit corrigé vers le bas lorsque le convertisseur analogique-numérique (65) effectue un réglage excessif, et corrige vers le haut lorsque le convertisseur analogique-numérique (65) effectue un réglage trop faible.

14. Procédé pour faire fonctionner un récepteur de hautes fréquences pour balayer une bande de fréquences avec au moins deux plages de fréquences (20a, 20b), dans lequel il est commuté, pour balayer la bande de fréquences, entre les au moins deux plages de fréquences; comportant un dispositif de réglage d'amplificateur (10) avec
un élément amplificateur (15) réglable en fonction d'un facteur d'amplification (30a, 30b) qui est couplé à un élément de sélection de plage de fréquences (20) pour régler au moins deux plages de fréquences (20a, 20b), dans lequel le fonctionnement est **caractérisé par** le fait de
mettre à disposition au moins deux facteurs d'amplification (30a, 30b) dans une mémoire (25), où les au moins deux facteurs d'amplification (30a, 30b) sont associés aux au moins deux plages de fréquences (20a, 20b);
régler un élément amplificateur réglable (15) selon le facteur d'amplification (30a, 30b) sélectionné dans la mémoire (25) en fonction d'une plage de fréquences actuelle pour la plage de fréquences actuelle; et
corriger le facteur d'amplification sélectionné (30a, 30b) sur base d'une analyse d'un signal amplifié (45) au moyen de l'élément amplificateur réglable (15) en fonction du facteur d'amplification sélectionné (30a, 30b) et mémoriser le facteur d'amplification corrigé (30a, 30b) dans la mémoire (25);
dans lequel sont calculés, pour corriger les facteurs d'amplification pour les plages de fréquences actuelles, à chaque itération des facteurs de correction adaptés.

15. Programme d'ordinateur avec un code de programme, dans lequel le code de programme est formé selon le procédé selon la revendication 14.
